# EUROPEAN PATENT SPECIFICATION

(11) **EP 2 466 917 B1**
(45) Date of publication and mention of the grant of the patent: **03.12.2014**
(21) Application number: 11187298.2
(22) Date of filing: 31.10.2011
(51) Int. Cl.: H04S 1/00, H03G 3/30, H03G 7/00

(54) **Audio-signal processing apparatus and method, and program**
Vorrichtung und Verfahren zur Audiosignalverarbeitung sowie Programm
Appareil de traitement d'un signal audio et procédé et programme

(30) Priority: 16.12.2010 JP 2010280164
(43) Date of publication of application: 20.06.2012
(73) Proprietor: Sony Corporation, Tokyo 108-0075 (JP)
(72) Inventor: Noguchi, Masayoshi, Minato-ku, Tokyo 108-0075 (JP)
(74) Representative: Berryman, Robert Jan

(56) References cited:
- EP-A1- 1 729 410
- EP-A2- 1 881 740
- WO-A1-2006/047600
- JP-A- H08 191 499

## Description

The present disclosure relates to an audio-signal processing apparatus and method, and program. In particular, the present disclosure relates to an audio-signal processing apparatus and method, and program that is suitable for use in the case of expanding a dynamic range of an audio signal.

When an audio signal is transmitted through a network, such as the Internet, etc., a transmittable peak value of the audio signal (hereinafter referred to as a maximum transmission level) is limited by capacity of a transmission line, a standard, etc. And if an audio signal is attenuated such that a peak value of the audio signal becomes not higher than a maximum transmission level, the wider an audio signal has a dynamic range, the lower an average value of the signal level (hereinafter referred to as an average level) becomes, and a sound-volume feeling is lost.

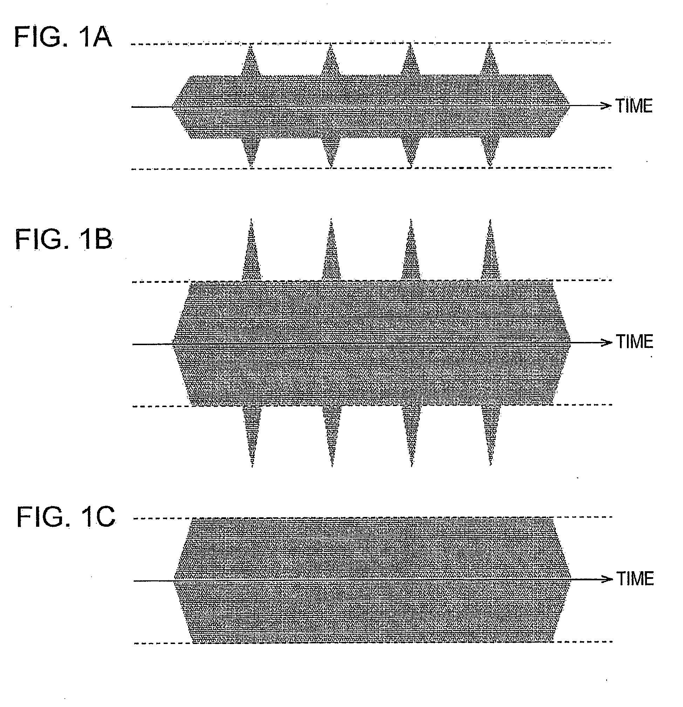

Thus, in order to increase a sound-volume feeling, there are cases where an audio signal is amplified to increase an average level once, then, components of the audio signal exceeding a maximum transmission level are cut or attenuated by a limiter circuit, etc., and the audio signal is transmitted. A description will be given of a specific example of this processing with reference to FIG. 1A to FIG. 1C.

Individual graphs in FIG. 1A to FIG. 1C schematically illustrate waveforms of an audio signal. The horizontal axis shows time, and the vertical axis shows a signal level. Also, dashed lines in FIG. 1A to FIG. 1C denote maximum transmission levels.

FIG. 1A illustrates an example of a waveform of an original audio signal. Also, FIG. 1B illustrates an example of a waveform of the audio signal after the audio signal is amplified and an average level of the audio signal is raised in order to increase a sound-volume feeling. Further, FIG. 1C illustrates an example of a waveform in which the audio signal in FIG. 1B has been subjected to limiter processing, and portions of the signal exceeding the maximum transmission level is cut. And the audio signal in FIG. 1C is transmitted through a network.

The audio signal in FIG. 1C has a high average level, but variations in the signal level become smaller compared with the audio signal in FIG. 1A. Accordingly, a sound-volume feeling increases compared with the original signal, whereas a dynamic range held by the original audio signal is lost, and the sound of the audio signal becomes flat and ambiguous.

On the other hand, to date, an expander has become widespread as a technique for expanding a dynamic range of an audio signal (for example, refer to Japanese Unexamined Patent Application Publication No. 2001-230647). The expander changes an amplification gain in accordance with an audio signal level so as to expand a dynamic range of the audio signal. Also, an expander enabling a user to adjust an expansion characteristic is provided.

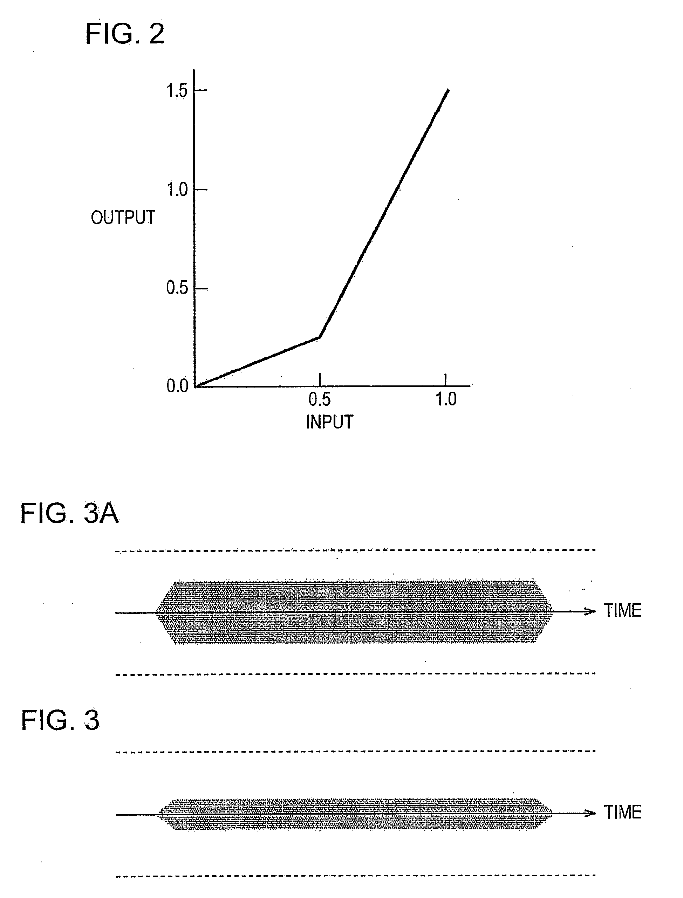

FIG. 2 illustrates an example of an input/output characteristic of a related-art expander. FIG. 2 illustrates a ratio of a level of an output signal (vertical axis) to a level of an input signal (horizontal axis).

Using an expander having this input/output characteristic, it is possible to make a small sound still smaller, and to make a loud sound further louder. As a result, it is possible to expand a dynamic range, and to obtain a sound that is nicely varied.

Here, consider the case where the dynamic range of the audio signal in FIG. 1C is expanded by an expander having an input/output characteristic in FIG. 2 with reference to FIG. 3A and FIG. 3B. In this regard, individual graphs in FIG. 3A and FIG. 3B illustrate a waveform of an audio signal in the same manner as FIG. 1A to FIG. 1C.

Normally, an average level of an audio signal is decreased to a predetermined value before the audio signal is input into the expander in order for a peak value of the audio signal not to become too high by expanding the dynamic range. For example, the audio signal in FIG. 1C has a high average level, and thus before being input into the expander, the average level is decreased to a predetermined value as shown in FIG. 3A.

FIG. 3B illustrates an example of a waveform of an audio signal that has been produced when the audio signal in FIG. 3A is subjected to dynamic-range expansion by an expander having the input/output characteristic in FIG. 2. In this manner, even if dynamic-range expansion is performed by an expander on an audio signal whose dynamic range has been lost once, it is difficult to recover the original dynamic range.

The present disclosure has been made in view of such circumstances. It is desirable to properly recover a dynamic range of an audio signal.

JPH 08191499 describes expanding an input dynamic range by providing two channels for balance control independently and supplying a control current for the case between minimum balance and center balance and for the case between center balance and maximum balance.

WO 2006/047600 relates to the measurement and control of the perceived sound loudness and/or the perceived spectral balance of an audio signal. An audio signal is modified in response to calculations performed at least in part in the perceptual (psychoacoustic) loudness domain.

EP 1729410 describes an audio compressor device for processing an audio signal and controlling a signal amplifier, comprising a signal analyser function devised to analyse an input signal during a time frame to determine if the signal represents noise or audio data, wherein the audio compressor device is adapted to set a gain for the signal amplifier dependent on the analysis. The analyser function may comprise an auto-correlation function, operative to perform auto-correlation of the input signal in a process for determining if the signal represents noise or audio data.

Particular and preferred aspects and embodiments of the present invention are set out in the accompanying independent and dependent claims. Features of the dependent claims may be combined with features of the independent claims as appropriate, and in combinations other than those explicitly set out in the claims.

The present invention will be described further, by way of example only, with reference to preferred embodiments thereof as illustrated in the accompanying drawings, in which:
FIG. 1A to FIG. 1C are diagrams for explaining an example of processing performed on an audio signal before transmission;
FIG. 2 is a graph illustrating an example of an input/output characteristic of an expander;
FIG. 3A and FIG. 3B are diagrams illustrating processing for expanding a dynamic range of an audio signal by an expander;
FIG. 4 is a block diagram illustrating an audio-signal processing apparatus according to a first embodiment of the present disclosure;
FIG. 5 is a block diagram illustrating an example of a functional configuration of an expansion-section detection device;
FIG. 6 is a flowchart illustrating dynamic-range expansion processing according to the first embodiment;
FIG. 7A to FIG. 7E are signal waveform diagrams illustrating dynamic-range expansion processing according to the first embodiment;
FIG. 8 is a flowchart for explaining details of expansion-section detection processing;
FIG. 9A to FIG. 9C are signal waveform diagrams for explaining details of expansion-section detection processing;
FIG. 10A and FIG. 10B are signal waveform diagrams illustrating an example of a result of dynamic-range expansion processing by the audio-signal processing apparatus according to the first embodiment;
FIG. 11 is a block diagram illustrating an audio-signal processing apparatus to which a second embodiment of the present disclosure is applied;
FIG. 12 is a flowchart for explaining dynamic-range expansion processing in the second embodiment;
FIG. 13A to FIG. 13G are signal waveform diagrams for explaining the dynamic-range expansion processing in the second embodiment;
FIG. 14A to FIG. 14G are signal waveform diagrams for explaining the dynamic-range expansion processing in the second embodiment; and
FIG. 15 is a block diagram illustrating an example of a configuration of a computer.

In the following, descriptions will be given of modes for carrying out the present disclosure (hereinafter called embodiments). In this regard, the descriptions will be given in the following order.
1. First embodiment (basic embodiment)
2. Second embodiment (example of suppressing excessive expansion of dynamic range)
3. Variations

### 1. First embodiment

Example of configuration of audio-signal processing apparatus

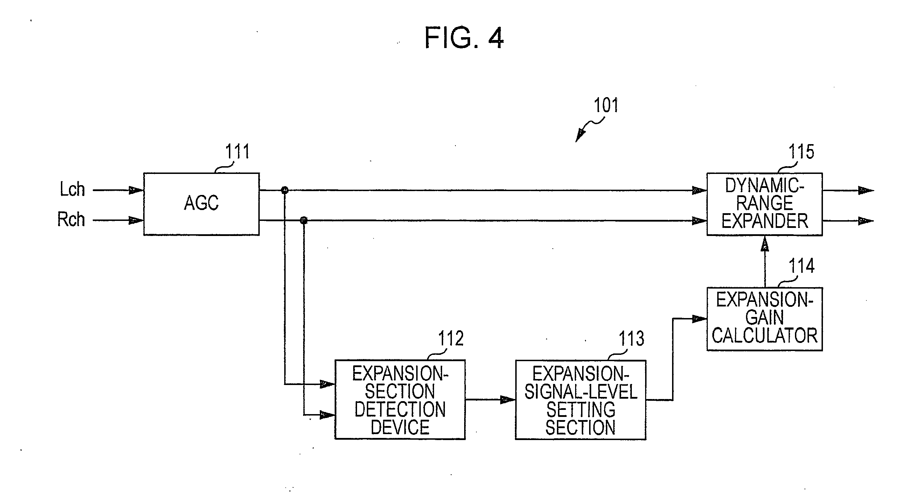

FIG. 4 is a block diagram illustrating an audio-signal processing apparatus to which a first embodiment of the present disclosure is applied.

An audio-signal processing apparatus 101 in FIG. 4 is, for example, an apparatus to which a stereo audio signal of two channels, namely right and left channels (Lch and Rch), is input, and which expands a dynamic range of the input audio signal (hereinafter referred to as an input signal) to output the signal. The audio-signal processing apparatus 101 includes an AGC (Auto Gain Control) 111, an expansion-section detection device 112, an expansion-signal-level setting section 113, an expansion-gain calculator 114, and a dynamic range expander 115.

The AGC 111 performs level correction so as to keep the input signal constant. The AGC 111 supplies the level-corrected input signal (hereinafter referred to as a corrected input signal) to the expansion-section detection device 112 and the dynamic range expander 115.

The expansion-section detection device 112 detects an expansion section in which a dynamic range of the input signal is expanded on the basis of the corrected input signal. The expansion-section detection device 112 supplies an expansion-section detection signal indicating the detected expansion section to the expansion-signal-level setting section 113.

The expansion-signal-level setting section 113 sets an expansion signal level indicating a level to which the dynamic range of the input signal is expanded on the basis of the expansion-section detection signal. The expansion-signal-level setting section 113 supplies an expansion-signal-level signal indicating the set expansion signal level to the expansion-gain calculator 114.

The expansion-gain calculator 114 calculates an expansion gain for expanding the dynamic range of the input signal on the basis of the expansion-signal-level signal. The expansion-gain calculator 114 supplies an expansion-gain signal indicating the calculated expansion gain to the dynamic range expander 115.

The dynamic range expander 115 amplifies the corrected input signal on the basis of the expansion-gain signal so as to expand the dynamic range of the corrected input signal. The dynamic range expander 115 outputs the audio signal (hereinafter referred to as an output signal) obtained as a result to the subsequent stage.

### Configuration of expansion-section detection device

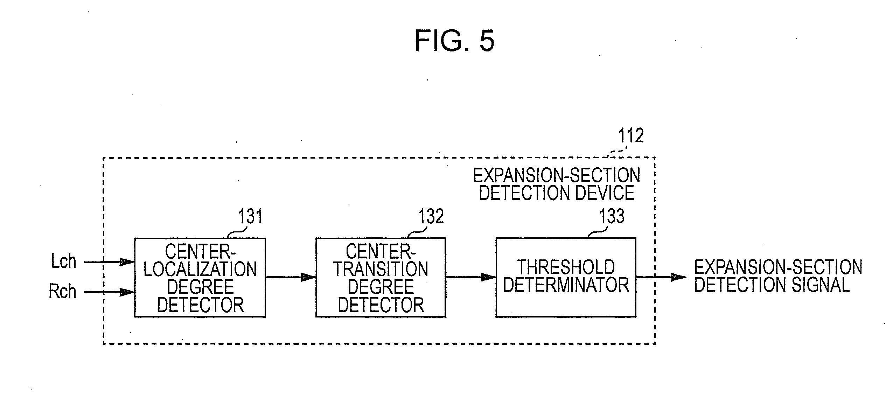

FIG. 5 is a block diagram illustrating an example of a configuration of the expansion-section detection device 112 in FIG. 4. The expansion-section detection device 112 includes a center-localization degree detector 131, a center-transition degree detector 132, and a threshold determinator 133.

The center-localization degree detector 131 detects a center localization degree indicating a degree of concentration on a center of a localization distribution of the corrected input signal supplied from the AGC 111. The center-localization degree detector 131 supplies a center-localization-degree detection signal indicating the detected center localization degree to the center-transition degree detector 132.

The center-transition degree detector 132 detects a degree of transition on a center of the localization distribution of the corrected input signal on the basis of the center-localization-degree detection signal. The center-transition degree detector 132 supplies a center-transition-degree detection signal indicating the detected center-transition degree to the threshold determinator 133.

The threshold determinator 133 detects an expansion section by comparing the center-transition-degree detection signal with a predetermined threshold value. The threshold determinator 133 supplies an expansion-section detection signal indicating the detected expansion section to the expansion-signal-level setting section 113.

### Dynamic-range expansion processing

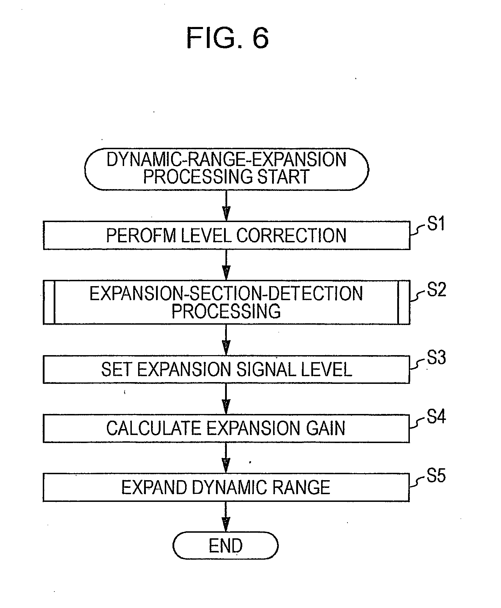

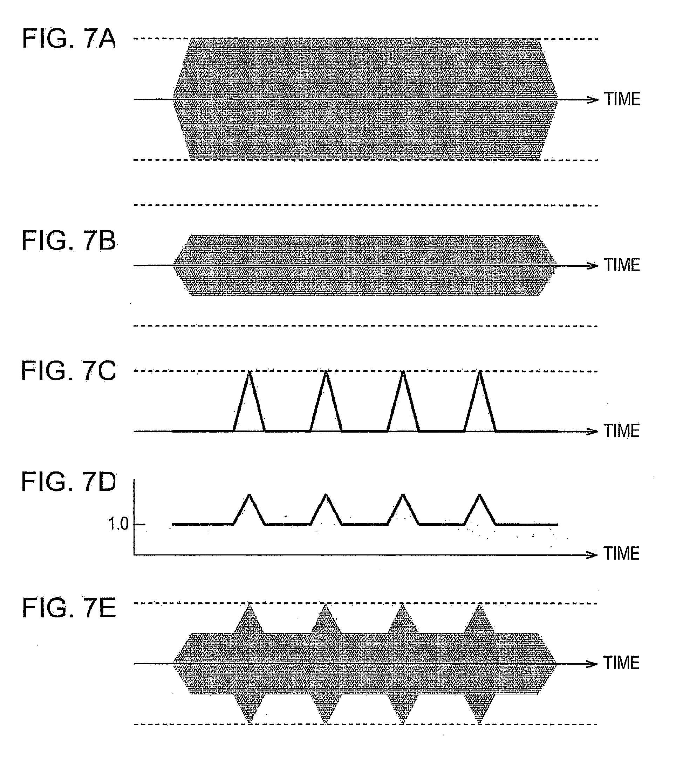

Next, a description will be given of dynamic-range expansion processing executed by the audio-signal processing apparatus 101 with reference to a flowchart in FIG. 6 and a signal waveform diagram in FIG. 7A to FIG. 7E. In this regard, this processing is started, for example, when an input signal is input into the audio-signal processing apparatus 101.

In this regard, individual graphs in FIG. 7A to FIG. 7E schematically illustrate waveforms of various signals to be processed by the dynamic-range expansion processing. The horizontal axis shows time, and the vertical axis shows a signal level. Also, dashed lines in FIG. 7A to FIG. 7C and FIG. 7E denote allowable audio-signal peak values (hereinafter referred to as maximum allowable peak levels).

Also, in the following, a description will be given of processing of the case where an input signal shown in FIG. 7A is input into the audio-signal processing apparatus 101 as a specific example. In this regard, the input signal in FIG. 7A is the same signal as the audio signal in FIG. 1C.

In step S1, the AGC 111 performs level correction. Specifically, the AGC 111 performs level correction on the input signal such that an average level of the individual channels becomes a predetermined reference level. Thereby, for example, the input signal in FIG. 7A is corrected as shown in FIG. 7B. The AGC 111 supplies the level-corrected input signal (the corrected input signal) to the center-localization degree detector 131 of the expansion-section detection device 112 and the dynamic range expander 115.

In this regard, a method of the AGC 111 performing level correction is not limited to a specific method, and any method may be employed.

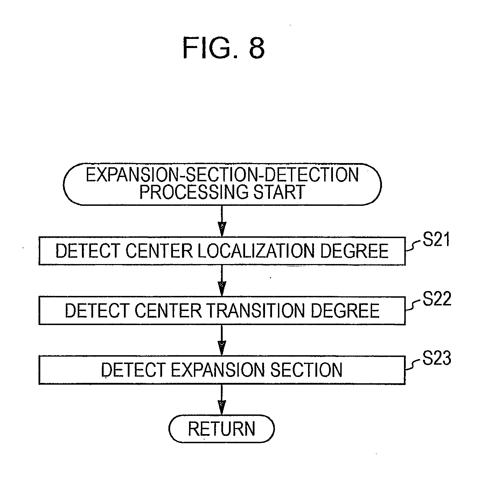

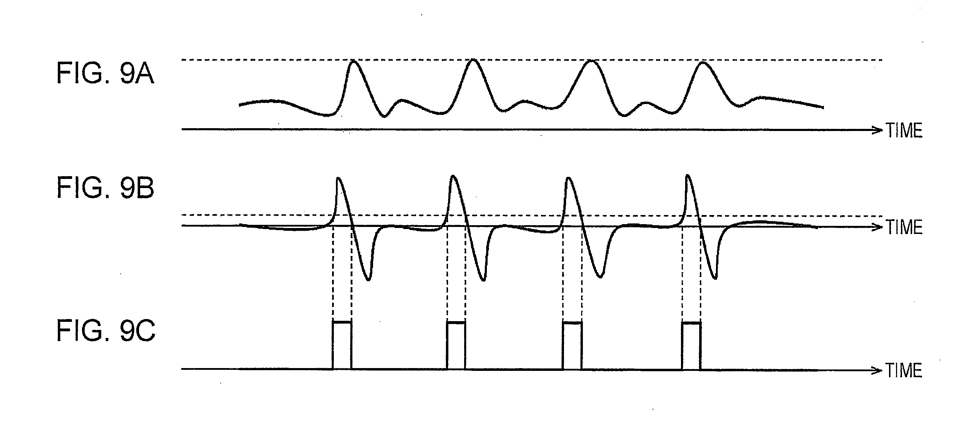

In step S2, the expansion-section detection device 112 executes expansion-section detection processing. Here, a detailed description will be given of the expansion-section detection processing with reference to a flowchart in FIG. 8 and signal waveform diagrams in FIG. 9A to FIG. 9C.

In this regard, individual graphs in FIG. 9A to FIG. 9C schematically illustrate waveforms of various signals to be processed by the expansion-section detection processing. The horizontal axis shows time, and the vertical axis shows a signal level.

In step S21, the center-localization degree detector 131 detects a center localization degree. Specifically, the center-localization degree detector 131 calculates a localization distribution of the corrected input signal on the basis of the corrected input signals of both right and left channels. Further, the center-localization degree detector 131 detects a center localization degree indicating how much a localization distribution of the corrected input signal is concentrated on a center on the basis of the calculated localization distribution. And the center-localization degree detector 131 supplies a center-localization-degree detection signal indicating the detected center localization degree to the center-transition degree detector 132.

FIG. 9A illustrates an example of a waveform of the center-localization-degree detection signal.

In this regard, in order to detect a localization distribution and a center localization degree of an audio signal, any method, for example, a method disclosed in Japanese Unexamined Patent Application Publication No. 2008-28693, etc., may be employed.

In step S22, the center-transition degree detector 132 detects a center-transition degree. Specifically, the center-transition degree detector 132 differentiates the center-localization-degree detection signal so as to generate a center-transition-degree detection signal indicating how much the localization distribution of the corrected input signal has changed to a center. And the center-transition degree detector 132 supplies the generated center-transition-degree detection signal to the threshold determinator 133.

FIG. 9B illustrates an example of a waveform of the center-transition-degree detection signal obtained by differentiating the center-localization-degree detection signal in FIG. 9A.

In step S23, the threshold determinator 133 detects an expansion section. Specifically, the threshold determinator 133 compares the center-transition-degree detection signal with a predetermined threshold value. And the threshold determinator 133 generates an expansion-section detection signal which becomes an H level (high level) during a section having the center-transition-degree detection signal not less than a threshold value, and becomes an L level (low level) during a section having the center-transition-degree detection signal less than the threshold value. A section in which the center-transition-degree detection signal becomes the threshold value or more, and the expansion-section detection signal becomes the H level is determined to be an expansion section. And the threshold determinator 133 supplies the generated expansion-section detection signal to the expansion-signal-level setting section 113.

FIG. 9C illustrates an example of a waveform of an expansion-section detection signal obtained as a result of a comparison of the center-transition-degree detection signal in FIG. 9B with a threshold value indicated by a dashed horizontal line.

In general, playback sound of a stereo audio signal, such as music, etc., is spread in right and left directions in room, and sound of rhythm instruments, vocal, etc., is concentrated around a center, and is localized. Accordingly, a localization distribution of an audio signal normally is spread in right and left directions, but a beginning phrase of a vocal, an attack sound of a rhythm instrument, etc., are rapidly concentrated on a center at a moment when a strong attack appears.

Also, even if amplitude of an audio signal is corrected by limit processing, etc., a localization distribution of an audio signal is not so much influenced by that correction, and is kept substantially unchanged. That is to say, a localization distribution of an audio signal seldom changes before and after amplitude of the audio signal is corrected.

Accordingly, by detecting a section having a center-transition degree not less than a threshold value, it is possible to detect a section in which a localization distribution of an audio signal rapidly changes, that is to say, to detect a section including a moment of the appearance of a strong attack as an expansion section.

After that, the expansion-section detection processing terminates.

Referring back to FIG. 6, in step S3, the expansion-signal-level setting section 113 sets an expansion signal level. Specifically, the expansion-signal-level setting section 113 generates an expansion-signal level signal that increases within a range not higher than a predetermined maximum value (hereinafter referred to as an expansion-signal peak level) in an expansion section in which the expansion-section detection signal becomes an H level, and that becomes a predetermined minimum value (hereinafter referred to as an expansion-signal minimum level) in a section in which the expansion-section detection signal becomes an L level. For example, the expansion-signal peak level is set to a maximum allowable peak level, and the expansion-signal minimum level is set to 0.

FIG. 7C illustrates an example of a waveform of an expansion-signal level signal generated on the basis of the corrected input signal in FIG. 7B and the expansion-section detection signal in FIG. 9C. In the expansion-signal level signal in FIG. 7C, an absolute value of an increasing slope of the signal level and an absolute value of a decreasing slope are equal, and, both of the slopes are individually set to be equal in all expansion sections. Accordingly, the expansion-signal level signal in FIG. 7C has a symmetrical mountain shape with the expansion-signal peak level as an apex in each expansion section. However, if the expansion section becomes further long, a period of maintaining the expansion-signal peak level becomes long, and the signal waveform becomes an isosceles trapezoid. On the other hand, if the expansion section is further shortened, a peak value does not reach the expansion-signal peak level.

And the expansion-signal-level setting section 113 supplies the generated expansion-signal level signal to the expansion gain calculator 114.

In step S4, the expansion-gain calculator 114 calculates an expansion gain. Specifically, the expansion-gain calculator 114 converts a value of the expansion-signal level signal such that the expansion-signal peak level becomes a predetermined maximum value (for example, 2.0) and the expansion-signal minimum level becomes 1.0. Thereby, the expansion-gain signal is generated.

FIG. 7D illustrates an example of a waveform of the expansion-gain signal generated on the basis of the expansion-signal level signal in FIG. 7C. In this manner, a value of the expansion-gain signal (expansion gain) exceeds 1.0 in the expansion section, and becomes 1.0 in a section other than the expansion section.

And the expansion-gain calculator 114 supplies the generated expansion-gain signal to the dynamic range expander 115.

In step S5, the dynamic range expander 115 expands the dynamic range. Specifically, the dynamic range expander 115 amplifies the corrected input signal using the expansion gain indicated by the expansion-gain signal so as to expand the dynamic range.

Thereby, the dynamic range of the corrected input signal is expanded in an expansion section having the expansion gain exceeding 1.0. And as described above, the expansion section includes a moment at which a strong attack appears, and thus the strong attack appears in the original audio signal, making it possible to expand the dynamic range at the moment when the signal level becomes high. Accordingly, for example, it is possible to amplify the original audio signal in FIG. 1A and to perform limiter processing so that the dynamic range lost in the input signal in FIG. 7A can be properly recovered as shown in FIG. 7E. As a result, it is possible to reproduce the original lively sound.

And the dynamic range expander 115 outputs the audio signal (output signal) with the expanded dynamic range to the subsequent stage.

After that, the dynamic-range expansion processing is terminated.

### 2. Second embodiment

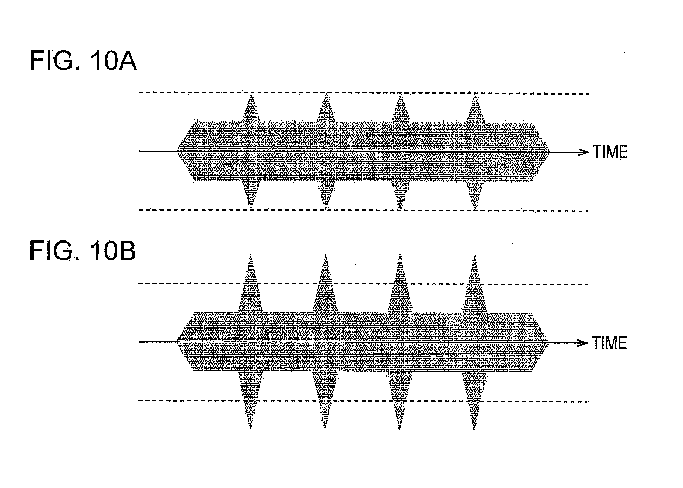

Incidentally, in the audio-signal processing apparatus 101, an audio signal is amplified unconditionally in an expansion section having an center-transition degree not less than a threshold value, and thus excessive expansion of a dynamic range is sometimes performed on an input signal. A description will be given of a specific example of this case with reference to FIG. 10A and FIG. 10B.

In this regard, the horizontal axes of individual graphs in FIG. 10A and FIG. 10B show time, the vertical axes show signal levels, and dashed lines show maximum allowable peak levels. Also, FIG. 10A illustrates an example of a waveform of an input signal that is input into the audio-signal processing apparatus 101, and is the same signal as the audio signal in FIG. 1A. FIG. 10B illustrates an example of a waveform of an output signal obtained by the audio-signal processing apparatus 101 as a result of expansion of the dynamic range of the input signal in FIG. 10A. In this manner, if the dynamic range of the input signal is wide, and the peak value is close to a maximum allowable peak level, a peak value of the output signal after expanding the dynamic range might exceeds the maximum allowable peak level.

A second embodiment of the present disclosure allows suppression of such excessive expansion of a dynamic range.

### Example of configuration of audio-signal processing apparatus

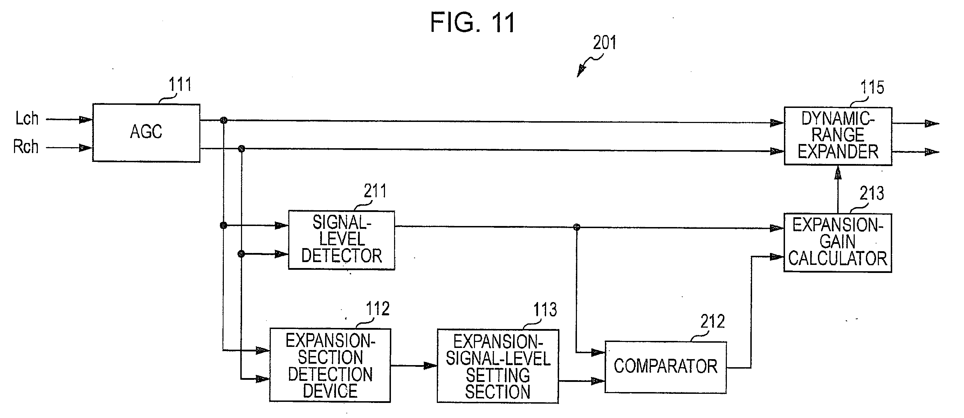

FIG. 11 is a block diagram illustrating an audio-signal processing apparatus to which the second embodiment of the present disclosure is applied. In this regard, in the figure, a same reference numeral is given to a common part as that in FIG. 4, and a description will be suitably omitted on a part performing same processing in order to avoid repetition.

As compared with the audio-signal processing apparatus 101 in FIG. 4, the audio-signal processing apparatus 201 in FIG. 11 is different in that it has a signal-level detector 211 and a comparator 212 additionally, and is provided with an expansion-gain calculator 213 in place of the expansion-gain calculator 114. Also, as compared with the audio-signal processing apparatus 101, the audio-signal processing apparatus 201 is common to the audio-signal processing apparatus 101 in that it is provided with the AGC 111, the expansion-section detection device 112, the expansion-signal-level setting section 113, and the dynamic range expander 115.

The signal-level detector 211 detects a level of the corrected input signal supplied from the AGC 111, and supplies an input signal level signal indicating a detection result to the comparator 212 and the expansion-gain calculator 213.

The comparator 212 compares the input-signal level signal with the expansion-signal level signal supplied from the expansion-signal-level setting section 113, and supplies a comparator-output signal indicating a comparison result to the expansion-gain calculator 213.

The expansion-gain calculator 213 calculates an expansion gain on the basis of the input-signal level signal and the comparator-output signal. The expansion-gain calculator 213 supplies the expansion-gain signal indicating the calculated expansion gain to the dynamic range expander 115.

### Dynamic-range expansion processing

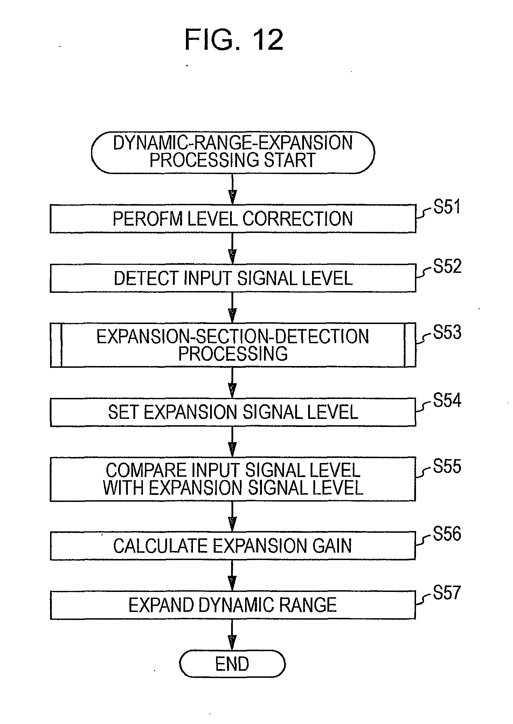

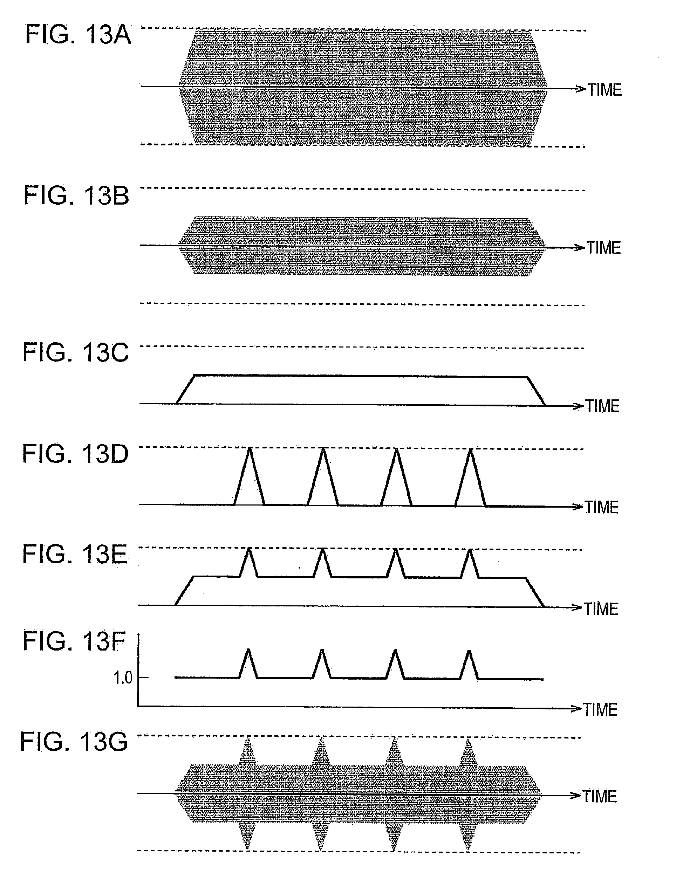

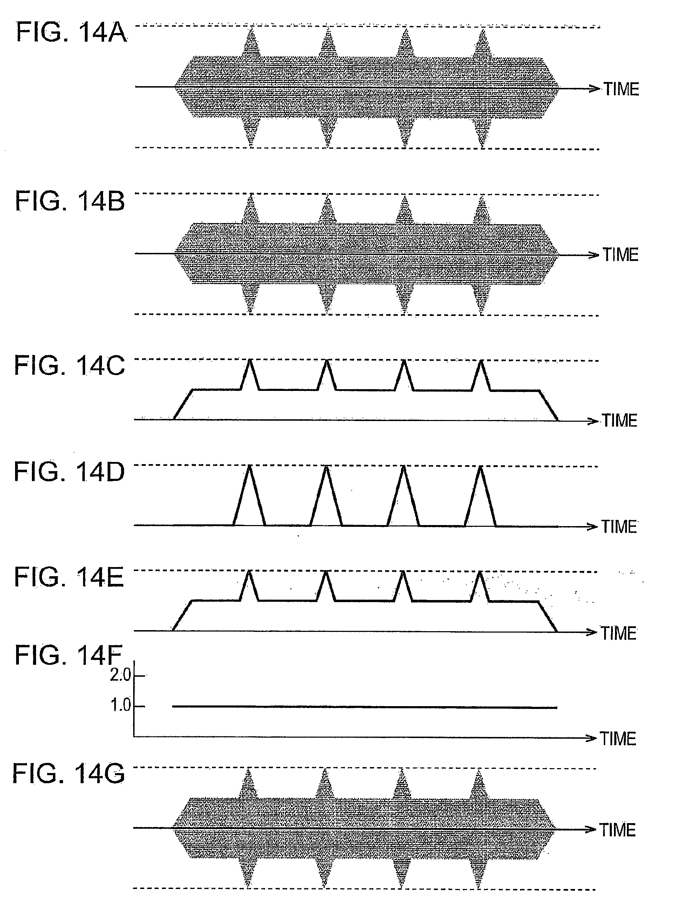

Next, a description will be given of dynamic-range expansion processing executed by the audio-signal processing apparatus 201 with reference to a flowchart in FIG. 12 and a signal waveform diagrams in FIG. 13A to FIG. 13G and FIG. 14A to FIG. 14G. In this regard, this processing is started, for example, when an input signal is input into the audio-signal processing apparatus 201.

In this regard, individual graphs in FIG. 13A to FIG. 13G and FIG. 14A to FIG. 14G schematically illustrate waveforms of various signals to be processed by the dynamic-range expansion processing. The horizontal axes show time, and the vertical axes show signal levels. Also, dashed lines in FIG. 13A to FIG. 13E, FIG. 13G, FIG. 14A to FIG. 14E, and FIG. 14G denote maximum allowable peak levels.

Also, in the following, a description will be given of processing of the case where an input signal shown in FIG. 13A is input into the audio-signal processing apparatus 201 and processing of the case where an input signal in FIG. 14A is input by properly comparing both of the processing. In this regard, the input signal in FIG. 13A is the same signal as the audio signal in FIG. 1C, and is an audio signal whose dynamic range has been lost by limiter processing, etc. On the other hand, the input signal in FIG. 14A is the same signal as the audio signal in FIG. 1A, and is an audio signal whose dynamic range has not been lost.

In step S51, level correction on the input signal is performed in the same processing as the processing in step S1 in FIG. 5.

FIG. 13B illustrates a waveform of the corrected input signal produced by performing level correction on the input signal in FIG. 13A, and is the same signal as the corrected input signal in FIG. 7B.

On the other hand, FIG. 14B illustrates an example of a waveform of the corrected input signal produced by performing level correction on the input signal in FIG. 14A. In this regard, in this example, in order to simplify the explanation, an example is shown in which an average level of the input signal in FIG. 14A is equal to a reference level, and the input signal in FIG. 14A and the corrected input signal in FIG. 14B are equal.

In step S52, the signal-level detector 211 detects the input signal level. For example, signal-level detector 211 detects an arithmetic mean of the corrected input signals of the right and left channels as an input signal level. The input-signal level detector 211 supplies an input-signal level signal indicating the detected input signal level to the comparator 212 and the expansion-gain calculator 213.

FIG. 13C illustrates an example of a waveform of the input-signal level signal for the corrected input signal in FIG. 13B. The input-signal level signal has a waveform with a narrow dynamic range in the same manner as the corrected input signal in FIG. 13B.

On the other hand, FIG. 14C illustrates an example of a waveform of the input-signal level signal for the corrected input signal in FIG. 14B. The input-signal level signal has a waveform with a wide dynamic range in the same manner as the corrected input signal in FIG. 14B.

In step S53, in the same manner as the processing in step S2 in FIG. 6, the expansion-section detection processing is performed. And as a result, the obtained expansion-section detection signal is supplied to the expansion-signal-level setting section 113 through the expansion-section detection device 112.

As described above, the localization distribution of the audio signal is seldom changed by the limiter processing, etc. Accordingly, substantially same sections are detected for the corrected input signals in FIG. 13B and FIG. 14B as expansion sections, and expansion-section detection signals having substantially same waveforms are generated. In this regard, in the following, it is assumed that same expansion-section detection signals as the above-described signal in FIG. 9C are generated for both of the corrected input signals in FIG. 13B and FIG. 14B.

In step S54, the expansion signal level is set in the same manner as the processing in step S3 in FIG. 6. The expansion-signal level signal obtained as a result is supplied from the expansion-signal-level setting section 113 to the comparator 212.

FIG. 13D illustrates an example of the expansion-signal level signal for the corrected input signal in FIG. 13B. FIG. 14D illustrates an example of the expansion-signal level signal for the corrected input signal in FIG. 14B. In this regard, the expansion-signal level signals in FIG. 13D and FIG. 14D are the same as the expansion-signal level signal in FIG. 7C.

In step S55, the comparator 212 compares the input signal level with the expansion signal level. Specifically, the comparator 212 compares the input signal level indicated by the input-signal level signal with the expansion signal level indicated by the expansion-signal level signal, and selects and outputs either higher one. Thereby, a comparator-output signal indicating a higher level between the input signal level and the expansion signal level at each point in time is generated, and is supplied from the comparator 212 to the expansion-gain calculator 213.

FIG. 13E illustrates an example of a waveform of the comparator-output signal obtained as a result of the comparison between the input-signal level signal in FIG. 13C and the expansion-signal level signal in FIG. 13D. In this case, the expansion signal level exceeds the input signal level in the vicinity of a center of each expansion section substantially matching a section in which the dynamic range of the input signal in FIG. 13A is lost, and thus the expansion signal level is selected. On the other hand, the expansion signal level does not exceed the input signal level in the other sections, and thus the input signal level is selected.

On the other hand, FIG. 14E illustrates an example of a waveform of a comparator-output signal obtained as a result of a comparison between the input-signal level signal in FIG. 14C and the expansion-signal level signal in FIG. 14D. In this case, the expansion signal level does not exceed the input-signal level signal in the expansion section too, and thus the input signal level is selected. Also, in the other sections, the expansion signal level does not exceed the input signal level, and thus the input signal level is selected. Accordingly, the comparator-output signal in FIG. 14E becomes the same signal as the input-signal level signal in FIG. 14C.

In step S56, the expansion-gain calculator 213 calculate an expansion gain. Specifically, the expansion-gain calculator 213 calculates the comparator-output signal value / the input-signal level signal value (input signal level) as the expansion gain. And the expansion-gain calculator 213 generates an expansion-gain signal indicating the calculated expansion gain, and supplies it to the dynamic range expander 115.

FIG. 13F illustrates an example of a waveform of the expansion-gain signal obtained from the input-signal level signal in FIG. 13C and the comparator-output signal in FIG. 13E. In this case, the expansion gain becomes higher than 1.0 in a section in which the expansion-signal level signal in FIG. 13E exceeds the input-signal level signal in FIG. 13C, and becomes 1.0 in other sections.

On the other hand, FIG. 14F illustrates an example of a waveform of the expansion-gain signal obtained from the input-signal level signal in FIG. 14C and the comparator-output signal in FIG. 14E. In this case, there is no section in which the expansion-signal level signal in FIG. 14E exceeds the input-signal level signal in FIG. 14C, and thus the expansion gain becomes 1.0 all the time.

In step S57, the corrected input signal is amplified, and the dynamic range is expanded by the same processing as that in step S5 in FIG. 6 on the basis of the expansion gain indicated by the expansion-gain signal. And the audio signal (output signal) whose dynamic range has been expanded is output from the dynamic range expander 115 to the subsequent stage.

FIG. 13G illustrates an example of a waveform of the audio signal (output signal) produced by amplifying the corrected input signal in FIG. 13B on the basis of the expansion-gain signal in FIG. 13F to expand the dynamic range. In this case, the dynamic range of the corrected input signal is expanded in a section where the expansion-gain signal value exceeds 1.0. In this manner, for an input signal having a narrow dynamic range, a signal in a section where the dynamic range has been lost is amplified, and thus the dynamic range held by the original audio signal can be properly recovered.

On the other hand, FIG. 14G illustrates an example of a waveform of the audio signal (output signal) produced by amplifying the corrected input signal in FIG. 14B on the basis of the expansion-gain signal in FIG. 14F to expand the dynamic range. In this case, the expansion-gain signal value is 1.0 all the time, and thus the corrected input signal in FIG. 14B is directly output. In this manner, for an audio signal having a wide dynamic range, excessive expansion of a dynamic range is suppressed, and thus it is possible to prevent the occurrence of distortion of the audio signal, etc.

After that, the dynamic-range expansion processing is terminated.

### 2. Variation

In the following, a description will be given of variations of the embodiments of the present disclosure.

### Variation 1

In the above description, expansion sections are detected on the basis of the corrected input signal after having been subjected to level correction. However, as described above, a localization distribution of an audio signal is hardly influenced by level correction, and thus expansion sections may be detected on the basis of the input signal before having been subjected to level correction.

### Variation 2

Also, in the above description, expansion sections are detected on the basis of a center-transition degree. However, expansion sections may be detected on the basis of a center localization degree. For example, a section having a center localization degree of a predetermined threshold value or higher may be detected as an expansion section. Thereby, it is possible to expand a dynamic range of a section in which a localization distribution of an input signal is concentrated on a center, for example, a section having a large sound volume of vocal and rhythm instruments. Also, expansion sections may be detected using both the center localization degree and the center-transition degree.

### Variation 3

Also, a peak value of the expansion-signal level signal and the slope of the expansion-signal level signal at increase time or decrease time may be varied on the basis of, for example, a length of an expansion section, and a level of the corrected input signal. Also, in FIG. 7C, an example is shown in which the slopes of the expansion-signal level signal at rising time and falling time are symmetrical (that is to say, the absolute values of the slopes are equal and the signs of the slopes are different). However, the signals at rising time and falling time are not necessary symmetrical. For example, the signal may rise fast, and then may gradually attenuate.

### Variation 4

Further, if the average levels are arranged to be equal before input, and then the input signal is input, it is possible to eliminate the AGC 111, and to omit the level correction processing.

### Variation 5

Also, when dynamic-range expansion processing is performed on a multi-channel input signal, for example, down mix ought to be performed on the audio signals of three front-side channels, namely the right, the left, and center channels. And expansion sections ought to be detected on the basis of the generated audio signal. And on the basis of the detected expansion sections, the dynamic-range expansion ought to be performed only on the audio signals of the three front-side channels.

In this regard, it is possible to apply the present disclosure, for example, to an apparatus performing playback or recording of an audio signal, or an apparatus performing correction of an audio signal.

Also, in the present specification, the audio signal includes a sound signal including only a human voice and a cry of an animal, etc.

### Example of configuration of computer

The above-described series of processing can be executed by hardware or can be executed by software. When the series of processing is executed by software, programs of the software may be installed in a computer. Here, the computer includes a computer that is built in a dedicated hardware, and for example, a general-purpose personal computer, etc., capable of executing various functions by installing various programs.

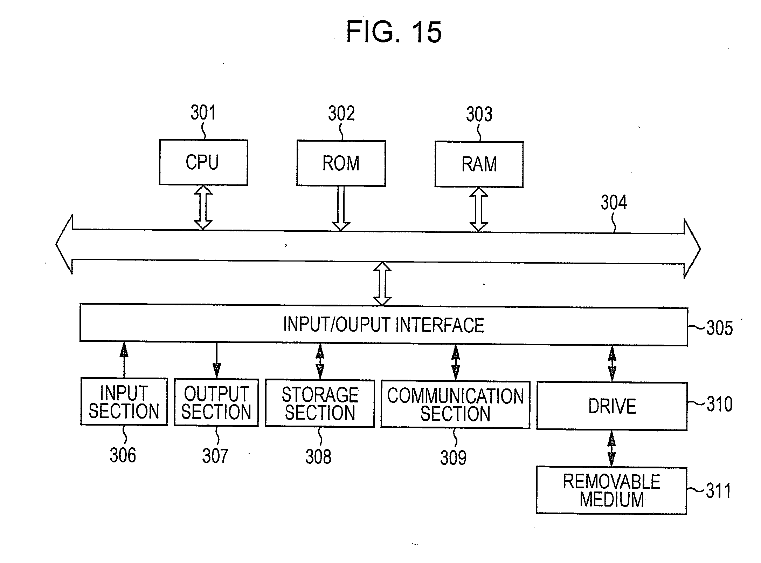

Fig. 15 is a block diagram illustrating an example of a hardware configuration of a computer which executes the above-described series of processing by programs.

In the computer, a CPU (Central Processing Unit) 301, a ROM (Read Only Memory) 302, a RAM (Random Access Memory) 303 are mutually connected through a bus 304.

An input/output interface 305 is further connected to the bus 304. An input section 306, an output section 307, a storage section 308, a communication section 309, and a drive 310 are connected to the input/output interface 305.

The input section 306 includes a keyboard, a mouse, a microphone, etc. The output section 307 includes a display, a speaker, etc. The storage section 308 includes a hard disk, a nonvolatile memory, etc. The communication section 309 includes a network interface, etc. The drive 310 drives a removable medium 311, such as a magnetic disk, an optical disc, a magneto-optical disc, or a semiconductor memory, etc.

In the computer having the configuration as described above, the CPU 301 loads the program stored, for example in storage section 308 to the RAM 303 through the input/output interface 305 and the bus 304 to execute the program, thereby the above-described series of processing is performed.

The program to be executed by the computer (CPU 301) can be provided by being recorded on a removable medium 311 as a package medium, etc., for example. Also, the program can be provided through a wired or a wireless transmission medium, such as a local area network, the Internet, a digital satellite broadcasting, etc.

In the computer, the programs can be installed in the storage section 308 through the input/output interface 305 by attaching the removable medium 311 to the drive 310. Also, the program can be received by the communication section 309 through a wired or wireless transmission medium and can be installed in the storage section 308. In addition, the program may be installed in the ROM 302 or the storage section 308 in advance.

In this regard, the programs to be executed by the computer may be programs that are processed in time series in accordance with the sequence described in this specification. Alternatively, the programs may be the programs to be executed in parallel or at necessary timing, such as at the time of being called, or the like.

Also, an embodiment of the present disclosure is not limited to the above-described embodiments. It is possible to make various changes.

The present disclosure contains subject matter related to that disclosed in Japanese Priority Patent Application JP 2010-280164 filed in the Japan Patent Office on December 16, 2010.

In so far as the embodiments of the invention described above are implemented, at least in part, using software-controlled data processing apparatus, it will be appreciated that a computer program providing such software control and a transmission, storage or other medium by which such a computer program is provided are envisaged as aspects of the present invention.

## Claims

1. An audio-signal processing apparatus (101) comprising:
a center-localization-degree detector (131) configured to detect a center-localization degree indicating a degree of concentration on a center of localization distribution of a multi-channel audio signal comprising at least two audio channels;
an expansion-section detector (133) configured to detect an expansion section for expanding a dynamic range of the audio signal on the basis of the center-localization degree; and
an expander (115) configured to expand the dynamic range of the audio signal in the expansion section;
**characterised in that**
the expansion-section detector is configured to detect a section as being the expansion section having a center-transition degree indicating a degree of transition of the audio signal on the center of localization distribution not less than a predetermined threshold value.

2. The audio-signal processing apparatus according to claim 1, wherein the center-transition degree is a derivative of the center-localization degree.

3. The audio-signal processing apparatus according to claim 1, wherein the expansion-section detector is configured to detect a section as being the expansion section having the center-localization degree not less than a predetermined threshold value.

4. The audio-signal processing apparatus according to claim 1, further comprising:
an input-signal-level detector (211) configured to detect an input signal level indicating a level of the audio signal; and
an expansion-signal-level setter (113) configured to set an expansion signal level indicating an expansion level of the dynamic range of the audio signal and having a predetermined minimum value in a section different from the expansion section and changing within a range not higher than a predetermined maximum value in the expansion section,
wherein the expander is configured to expand the dynamic range of the audio signal in a section having the expansion signal level higher than the input signal level.

5. The audio-signal processing apparatus according to claim 4, further comprising:
a comparator (212) configured to compare the input signal level and the expansion signal level, and configured to output either higher one of the levels; and
an expansion-gain calculator (213) configured to calculate an expansion gain on the basis of the output value of the comparison section and the input signal level,
wherein the expander is configured to amplify the audio signal on the basis of the expansion gain so as to expand the dynamic range of the audio signal.

6. The audio-signal processing apparatus according to claim 1, further comprising
a corrector (111) configured to correct the level of the audio signal so as to keep the signal at a constant level,
wherein the center-localization-degree detector is configured to detect a center-localization degree of the corrected audio signal, and the expander is configured to expand the dynamic range of the corrected audio signal.

7. A method of processing an audio signal by an audio-signal processing apparatus expanding a dynamic range of the audio signal, wherein the audio signal is a multi-channel audio signal comprising at least two audio channels, the method comprising:
detecting a center-localization degree (S21) indicating a degree of concentration on a center of localization distribution of the audio signal;
detecting an expansion section (S23) expanding the dynamic range of the audio signal on the basis of the center-localization degree; and
expanding the dynamic range (S57) of the audio signal in the expansion section;
**characterised in that**
the step of detecting an expansion section detects a section as being the expansion section having a center-transition degree indicating a degree of transition of the audio signal on the center of localization distribution not less than a predetermined threshold value.

8. A program for causing a computer to perform the method according to claim 7.

## Patentansprüche

1. Audiosignalverarbeitungsvorrichtung (101), umfassend:
einen Mittenlokalisierungsgraddetektor (131), ausgelegt zum Detektieren eines Mittenlokalisierungsgrads, der einen Grad der Konzentration auf eine Mitte einer Ortbestimmungsverteilung eines Mehrkanalaudiosignals mit mindestens zwei Audiokanälen angibt;
einen Erweiterungsabschnittsdetektor (133), ausgelegt zum Detektieren eines Erweiterungsabschnitts zum Erweitern eines Dynamikumfangs des Audiosignals auf der Basis des Mittenlokalisierungsgrads; und
einen Erweiterer (115), ausgelegt zum Erweitern des Dynamikumfangs des Audiosignals in dem Erweiterungsabschnitt;
**dadurch gekennzeichnet, dass** der Erweiterungsabschnittsdetektor ausgelegt ist, einen Abschnitt als den Erweiterungsabschnitt mit einem Mittenübergangsgrad, der einen Grad des Übergangs des Audiosignals in der Mitte der Ortbestimmungsverteilung von nicht weniger als einem vorbestimmten Schwellenwert angibt, zu detektieren.

2. Audiosignalverarbeitungsvorrichtung nach Anspruch 1, wobei der Mittenübergangsgrad eine Ableitung des Mittenlokalisierungsgrads ist.

3. Audiosignalverarbeitungsvorrichtung nach Anspruch 1, wobei der Erweiterungsabschnittsdetektor ausgelegt ist zum Detektieren eines Abschnitts als den Erweiterungsabschnitt mit dem Mittenlokalisierungsgrad von nicht weniger als einem vorbestimmten Schwellenwert.

4. Audiosignalverarbeitungsvorrichtung nach Anspruch 1, ferner umfassend:
einen Eingangssignalpegeldetektor (211), ausgelegt zum Detektieren eines Eingangssignalpegels, der einen Pegel des Audiosignals angibt; und
einen Erweiterungssignalpegelsetzer (113), ausgelegt zum Setzen eines Erweiterungssignalpegels, der einen Erweiterungspegel des Dynamikumfangs des Audiosignals angibt und der einen vorbestimmten Minimalwert in einem von dem Erweiterungsabschnitt verschiedenen Abschnitt aufweist und der innerhalb eines Umfangs wechselt, der nicht höher als ein vorbestimmter Maximalwert in dem Erweiterungsabschnitt ist,
wobei der Erweiterer ausgelegt ist, den Dynamikumfang des Audiosignals in einem Abschnitt mit dem Erweiterungssignalpegel höher als dem Eingangssignalpegel zu erweitern.

5. Audiosignalverarbeitungsvorrichtung nach Anspruch 4, ferner umfassend:
einen Vergleicher (212), ausgelegt zum Vergleichen des Eingangssignalpegels und des Erweiterungspegels und ausgelegt zum Ausgeben des jeweils höheren Wertes, und
einen Erweiterungsverstärkungsberechner (213), ausgelegt zum Berechnen einer Erweiterungsverstärkung auf der Basis des Ausgabewerts des Vergleichsabschnitts und des Eingangssignalpegels,
wobei der Erweiterer ausgelegt ist zum Verstärken des Audiosignals auf der Basis der Erweiterungsverstärkung, um den Dynamikumfang des Audiosignals zu erweitern.

6. Audiosignalverarbeitungsvorrichtung nach Anspruch 1, ferner umfassend:
einen Korrigierer (111), ausgelegt zum Korrigieren des Pegels des Audiosignals, um das Signal auf einem konstanten Pegel zu halten,
wobei der Mittenlokalisierungsgraddetektor ausgelegt ist zum Detektieren eines Mittenlokalisierungsgrads des korrigierten Audiosignals und der Erweiterer ausgelegt ist zum Erweitern des Dynamikumfangs des korrigierten Audiosignals.

7. Verfahren zum Verarbeiten eines Audiosignals durch eine Audiosignalverarbeitungsvorrichtung, die einen Dynamikumfang des Audiosignals erweitert, wobei das Audiosignal ein Mehrkanalaudiosignal mit mindestens zwei Audiokanälen ist, wobei das Verfahren die folgenden Schritte umfasst:
Detektieren eines Mittenlokalisierungsgrads (S21), der einen Grad der Konzentration auf eine Mitte der Ortbestimmungsverteilung des Audiosignals angibt;
Detektieren eines Erweiterungsabschnitts (S23), der den Dynamikumfang des Audiosignals auf der Basis des Mittenlokalisierungsgrads erweitert; und
Erweitern des Dynamikumfangs (S57) des Audiosignals in dem Erweiterungsabschnitt;
**dadurch gekennzeichnet, dass** der Schritt des Detektierens eines Erweiterungsabschnitts einen Abschnitt als den Erweiterungsabschnitt mit einem Mittenlokalisierungsgrad erkennt, der einen Grad des Übergangs des Audiosignals in der Mitte der Ortbestimmungsverteilung von nicht weniger als einem vorbestimmten Schwellenwert angibt.

8. Programm, um einen Computer zu veranlassen, das Verfahren nach Anspruch 7 durchzuführen.

## Revendications

1. Appareil de traitement de signal audio (101) comprenant :
un détecteur de degré de localisation de centre (131) configuré pour détecter un degré de localisation de centre indiquant un degré de concentration sur un centre d'une distribution de localisation d'un signal audio multicanaux comprenant au moins deux canaux audio ;
un détecteur de section d'extension (133) configuré pour détecter une section d'extension pour étendre une plage dynamique du signal audio en fonction du degré de localisation de centre ; et
un extenseur (115) configuré pour étendre la plage dynamique du signal audio dans la section d'extension ; **caractérisé en ce que**
le détecteur de section d'extension est configuré pour détecter une section comme étant la section d'extension ayant un degré de transition de centre indiquant un degré de transition du signal audio sur le centre de la distribution de localisation non inférieur à une valeur de seuil prédéterminée.

2. Appareil de traitement de signal audio selon la revendication 1,
dans lequel le degré de transition de centre est dérivé du degré de localisation de centre.

3. Appareil de traitement de signal audio selon la revendication 1,
dans lequel le détecteur de section d'extension est configuré pour détecter une section comme étant la section d'extension ayant le degré de localisation de centre non inférieur à une valeur de seuil prédéterminée.

4. Appareil de traitement de signal audio selon la revendication 1, comprenant en outre :
un détecteur de niveau de signal d'entrée (211) configuré pour détecter un niveau de signal d'entrée indiquant un niveau du signal audio ; et
un élément de réglage de niveau de signal d'extension (113) configuré pour régler un niveau de signal d'extension indiquant un niveau d'extension de la plage dynamique du signal audio et ayant une valeur minimum prédéterminée dans une section différente de la section d'extension et changeant dans une plage non supérieure à une valeur maximum prédéterminée dans la section d'extension,
dans lequel l'élément d'extension est configuré pour étendre la plage dynamique du signal audio dans une section ayant le niveau de signal d'extension supérieur au niveau de signal d'entrée.

5. Appareil de traitement de signal audio selon la revendication 4, comprenant en outre :
un comparateur (212) configuré pour comparer le niveau de signal d'entrée et le niveau de signal d'extension, et configuré pour restituer le plus haut de l'un ou l'autre des niveaux ; et
un calculateur de gain d'extension (213) configuré pour calculer un gain d'extension en fonction de la valeur de restitution de la section de comparaison et du niveau de signal d'entrée,
dans lequel l'extenseur est configuré pour amplifier le signal audio en fonction du gain d'extension de manière à étendre la plage dynamique du signal audio.

6. Appareil de traitement de signal audio selon la revendication 1, comprenant en outre :
un correcteur (111) configuré pour corriger le niveau du signal audio de manière à maintenir le signal à un niveau constant,
dans lequel le détecteur de degré de localisation de centre est configuré pour détecter un degré de localisation de centre du signal audio corrigé, et
l'extenseur est configuré pour étendre la plage dynamique du signal audio corrigé.

7. Procédé de traitement d'un signal audio par un appareil de traitement de signal audio qui étend une plage dynamique du signal audio, le signal audio étant un signal audio multicanaux comprenant au moins deux canaux audio, le procédé comprenant :
la détection d'un degré de localisation de centre (S21) indiquant un degré de concentration sur un centre de distribution de localisation du signal audio ;
la détection d'une section d'extension (S23) étendant la plage dynamique du signal audio en fonction du degré de localisation de centre ; et
l'extension de la plage dynamique (S57) du signal audio dans la section d'extension ; **caractérisé en ce que** l'étape de détection d'une section d'extension détecte une section comme étant la section d'extension ayant un degré de transition de centre indiquant un degré de transition du signal audio sur le centre de la distribution de localisation non inférieur à une valeur de seuil prédéterminée.

8. Programme destiné à amener un ordinateur à exécuter le procédé selon la revendication 7.
